Europäisches Patentamt

European Patent Office

Office européen des brevets

(19)

(11) EP 0 654 825 B1

(12) **FASCICULE DE BREVET EUROPEEN**

(45) Date de publication et mention
de la délivrance du brevet:
**24.03.1999 Bulletin 1999/12**

(51) Int Cl.$^6$: **H01L 25/04**, H01L 27/148

(21) Numéro de dépôt: **94402589.9**

(22) Date de dépôt: **16.11.1994**

(54) **Dispositif de détection de rayonnement, à éléments de détection aboutés, et procédé de fabrication de ce dispositif**

Vorrichtung zur Strahlungsdetektion mit aneinanderstossenden Detektionselementen sowie Verfahren zur Herstellung dieser Vorrichtung

Radiation detection device with abutting detection elements and method of manufacturing this device

(84) Etats contractants désignés:
**DE GB IT**

(30) Priorité: **17.11.1993 FR 9313721**

(43) Date de publication de la demande:
**24.05.1995 Bulletin 1995/21**

(73) Titulaire: **COMMISSARIAT A L'ENERGIE ATOMIQUE**
**75015 Paris (FR)**

(72) Inventeurs:
• **Cigna, Jean-Charles**
  **F-38250 Villard de Lans (FR)**
• **Petitprez, Claudine**
  **F-38190 Lancey (FR)**
• **Marion, François**
  **F-38120 Saint Egreve (FR)**
• **Ravetto, Michel**
  **F-38240 Meylan (FR)**

(74) Mandataire: **Dubois-Chabert, Guy et al**
**c/o BREVATOME**
**25, rue de Ponthieu**
**75008 Paris (FR)**

(56) Documents cités:
   EP-A- 0 201 396          FR-A- 2 644 632
   US-A- 4 695 861

• PATENT ABSTRACTS OF JAPAN vol. 11, no. 77 (E-487) (2524) 7 Mars 1987 & JP-A-61 231 757 (SEIKO EPSON) 16 Octobre 1986
• OPTICAL ENGINEERING, vol.26, no.3, Mars 1987, BELLINGHAM US pages 201 - 208 K.VURAL 'Mercury cadmium telluride short- and medium-wavelength infrared staring focal plane arrays'
• PATENT ABSTRACTS OF JAPAN vol. 11, no. 77 (E-487) (2524) 7 Mars 1987 & JP-A-61
• 231 757 (SEIKO EPSON) 16 Octobre 1986

**Description**

La présente invention concerne un dispositif de détection de rayonnement, à éléments de détection aboutés, ainsi qu'un procédé de fabrication de ce dispositif.

L'invention s'applique en particulier à la réalisation de barrettes linéaires de détection optique linéaire de très grande longueur, notamment pour l'imagerie thermique.

Dans le domaine de la détection de signaux optiques, on a été progressivement amené à la fabrication de composants de taille de plus en plus importante.

A titre d'exemple, la fabrication de barrettes de photodétecteurs linéaires de grande longueur, comportant plus de 1000 pixels en ligne, est l'un des objectifs majeurs des fabricants.

Le nombre élevé de pixels de lecture requis pour ces détecteurs de type "barrette" exclut la fabrication de composants monolithiques pour des questions de taux de défauts et du fait des tailles limitées des substrats sur lesquels on fabrique ces détecteurs.

La technique la plus employée pour réaliser des barrettes de photodétecteurs de grande longueur est la technique dite "d'aboutage" qui est par exemple décrite dans l'article suivant :

"Recent developments on 12.5 µm infrared detection buttable linear arrays", dont les auteurs sont J.P. Chamonal, C. Lucas, P. Bouchut, D. Blachier et P. Angelbaut, publié dans Proceedings of SPIE Infrared Detectors and Focal Plane Arrays, vol.1685, à la date du 23 Avril 1992.

Cette technique consiste à juxtaposer, sur un substrat d'interconnexion, des barrettes élémentaires de photodétecteurs, sans perte de pixels, la taille totale de la barrette équivalente n'étant alors plus limitée par les facteurs mentionnés plus haut, à savoir le taux de défauts et la taille limitée des substrats sur lesquels on fabrique les photodétecteurs.

L'une des techniques possible d'aboutage consiste à fabriquer des éléments de détection, ou composants, comportant des photodétecteurs, ou pixels, et à couper les extrémités de ces composants au plus près de leurs pixels d'extrémité afin de pouvoir juxtaposer mécaniquement ces composants tout en conservant le pas de détection.

L'une des techniques permettant une telle juxtaposition est la technique dite d'hybridation "flip-chip", technique selon laquelle les composants sont hybridés par des billes de soudure sur un support de réseau d'interconnexion (ou encore sur un circuit de lecture).

Dans ce cas, les composants reçoivent le rayonnement à détecter par leurs faces-arrière.

La difficulté majeure de ce genre de technique est de découper les composants sans dégrader les pixels situés près du bord des découpes (du fait des contraintes mécaniques inévitablement engendrées par le découpage).

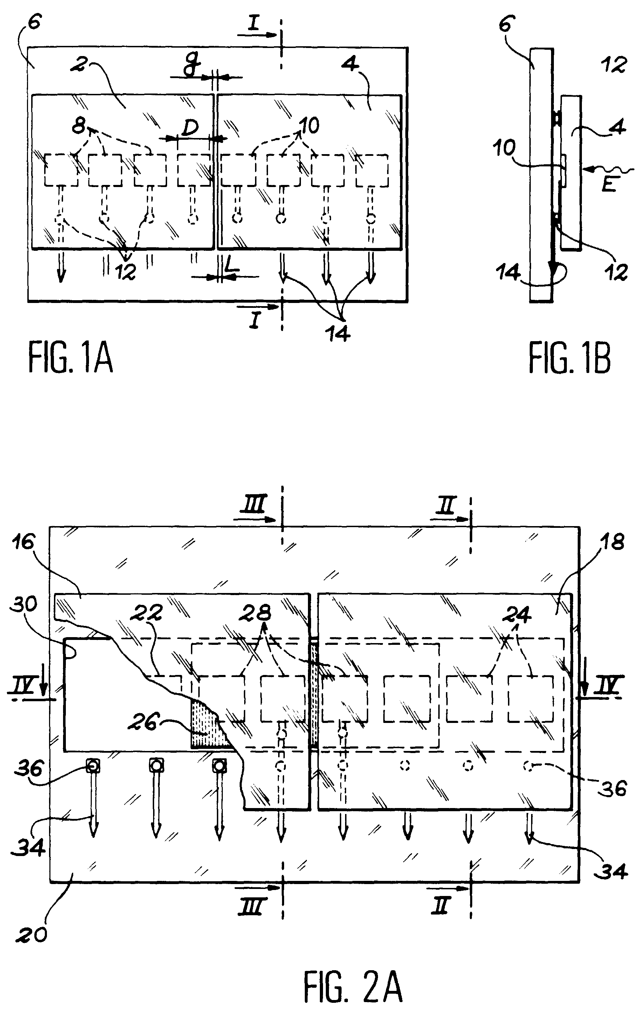

La figure 1A est une vue schématique de deux éléments de détection 2 et 4 aboutés et hybridés sur un support de réseau d'interconnexion 6 selon cette technique d'hybridation flip-chip.

La figure 1B est la coupe I-I de la figure 1A.

On voit sur ces figures 1A et 1B une rangée de photodétecteurs 8 que comporte l'élément 2 et une rangée de photodétecteurs 10 que comporte l'élément 4.

On a symbolisé sur la figure 1B par une flèche ondulée E l'éclairage, par la face-arrière, des éléments 2 et 4 (qui sont faits d'un matériau transparent au rayonnement que l'on veut détecter).

On voit sur les figures 1A et 1B des microbilles électriquement conductrices 12 permettant l'hybridation des éléments 2 et 4 sur le support 6 ainsi que la liaison des photodétecteurs 8 et 10 à des conducteurs de connexion 14 qui leurs sont associés sur le support 6.

Sur la figure 1A, la référence D représente la taille (optique) des photodétecteurs (qui sont par exemple des photodiodes) et la référence g représente la distance minimale entre deux bords de découpe adjacents, cette distance étant imposée par des considérations mécaniques (précision de découpe, précision de placement des puces contiguës).

La réduction du pas des pixels rend insurmontable la difficulté mentionnée plus haut (découper les composants sans dégrader les pixels situés près des bords de découpe) lorsqu'il peut être démontré que la distance entre les bords de découpe et les bords extérieurs des pixels les plus proches de ces bords de découpe ne peut pas être inférieure à une distance notée L sur la figure 1A.

Avec les notations utilisées, le pas P de détection (c'est-à-dire le pas de répétition des pixels) est au moins égal à :

$$P = D + 2L + g.$$

La réduction du pas de détection conduit alors à des tailles D de pixels réduites et éventuellement nulles, si les valeurs de L et g imposées par les différentes technologies sont grandes.

La présente invention vise à remédier aux inconvénients précédents en proposant un dispositif de photodétection susceptible d'avoir une très grande longueur ainsi qu'un procédé de fabrication de ce dispositif, l'invention évitant la dégradation des pixels des éléments de photodétection proches des bords des découpes.

De façon précise, la présente invention a pour objet un dispositif de détection de rayonnement, ce dispositif comprenant au moins deux éléments de détection aboutés, chaque élément étant fait d'un matériau transparent au rayonnement et ayant, sur une face, une pluralité de photodétecteurs aptes à détecter le rayonnement, ce dispositif étant caractérisé en ce qu'il comprend en outre, pour tout ensemble de deux éléments aboutés, un élément de détection complémentaire ayant, sur une face, une pluralité de photodétecteurs aptes à détecter le rayonnement, en ce que cet élément complémentaire est placé à cheval sur les deux éléments aboutés, les photodétecteurs de cet élément complémentaire étant en regard desdites faces de ces deux éléments aboutés, et en ce que ces deux éléments aboutés ne comportent aucun photodétecteur en regard des photodétecteurs de l'élément complémentaire.

Selon un mode de réalisation préféré de ce dispositif, celui-ci comprend en outre un substrat comportant au moins un perçage, ce perçage étant apte à recevoir l'élément complémentaire, les deux éléments aboutés sont hybridés sur le substrat par des billes électriquement conductrices et l'élément de détection complémentaire est relié au substrat par l'intermédiaire de connexions électriques formées sur les éléments aboutés et de billes électriquement conductrices.

Le substrat peut comprendre un seul perçage, apte à recevoir chaque élément complémentaire, ou une pluralité de perçages, chacun de ceux-ci étant apte à recevoir un élément complémentaire.

Chacun des éléments aboutés ainsi que l'élément complémentaire correspondant peuvent comprendre une rangée de photodétecteurs de pas déterminé, le nombre de photodétecteurs de l'élément complémentaire étant choisi de façon à obtenir, lorsque cet élément complémentaire est placé à cheval sur les éléments aboutés correspondants, une rangée unique de photodétecteurs ayant ledit pas déterminé.

L'invention concerne également un procédé de fabrication du dispositif conforme à l'invention, comprenant ledit substrat, ce procédé étant caractérisé en ce qu'il comprend les étapes suivantes :

- on fabrique le substrat pourvu dudit perçage,
- on réalise l'hybridation des éléments de détection aboutés sur ce substrat, et
- on assemble l'élément complémentaire à la structure ainsi obtenue, à travers le perçage du substrat.

La présente invention permet un aboutage (sans limitation géométrique de la taille des photodétecteurs) d'un nombre non limité d'éléments de détection.

L'invention permet également que le pas des photodétecteurs soit égal à D (taille optique des photodétecteurs).

L'invention permet en outre d'éloigner d'une distance choisie les bords d'aboutage des bords des premiers photodétecteurs utiles.

La présente invention sera mieux comprise à la lecture de la description d'exemples de réalisation donnés ci-après, à titre purement indicatif et nullement limitatif, en faisant référence aux dessins annexés sur lesquels :

- la figure 1A est une vue de dessus schématique d'un dispositif de détection de rayonnement connu et a déjà été décrite,
- la figure 1B est la coupe I-I de la figure 1A et a déjà été décrite,
- la figure 2A est une vue de dessus schématique d'un dispositif de détection de rayonnement conforme à l'invention,
- la figure 2B est la coupe II-II de la figure 2A,
- la figure 2C est la coupe III-III de la figure 2A,
- la figure 2D est la coupe IV-IV de la figure 2A, et
- la figure 3 est une vue en perspective schématique et partielle d'un autre dispositif de détection conforme à l'invention.

Le dispositif de détection de rayonnement conforme à l'invention, qui est schématiquement représenté sur les figures 2A à 2D, résulte d'une hybridation tridimensionnelle d'éléments de photodétection.

Etant donné des éléments aboutés, on a ajouté un autre élément suivant un axe perpendiculaire au plan défini par les éléments aboutés, cet autre élément étant placé au niveau de la jonction entre les deux éléments aboutés.

Plus précisément, le dispositif des figures 2A à 2D comprend une pluralité d'éléments de détection (deux dans l'exemple représenté), qui portent respectivement les références 16 et 18, ainsi qu'un support de réseau d'interconnexion 20.

Chacun des éléments 16 et 18 est fait d'un matériau transparent au rayonnement R à détecter et a, sur une face, une rangée de photodétecteurs apte à détecter ce rayonnement (il s'agit par exemple de photodiodes).

Les photodétecteurs de l'élément 16 portent la référence 22 tandis que les photodétecteurs de l'élément 18 portent la référence 24.

Le dispositif des figures 2A à 2D comprend en outre un élément de détection complémentaire 26 qui a, sur une face, une rangée de photodétecteurs 28 aptes à détecter le rayonnement et cet élément complémentaire est placé à cheval sur les deux éléments 16 et 18 aboutés.

Les photodétecteurs 28 de cet élément 26 sont en regard des faces des deux éléments 16 et 18, faces sur lesquelles sont formés les photodétecteurs 22 et 24.

Les éléments de détection 16 et 18 sont aboutés de façon standard sur le substrat d'interconnexion 20.

Ces deux éléments aboutés 16 et 18 ne comportent aucun photodétecteur en regard des photodétecteurs 28 de l'élément complémentaire 26.

Ce sont les photodétecteurs 28 de cet élément 26 qui jouent le rôle des photodétecteurs d'extrémité des éléments de détection de l'art antérieur.

Comme on le verra plus en détail par la suite, les éléments 16 et 18 sont hybridés par des billes de soudure sur le substrat 20 et l'élément complémentaire 26 est lui-même hybridé sur les éléments 16 et 18 par des billes de soudure, à travers un perçage longitudinal 30 que comporte le support de réseau d'interconnexion.

Comme on le verra mieux par la suite, les photodétecteurs 28 de l'élément 26 sont reliés au support de réseau d'interconnexion 20 par l'intermédiaire de connexions électriques, qui sont formées sur les éléments 16 et 18, et de billes de soudure.

L'élément de détection complémentaire 26 comprend, dans l'exemple représenté, plus de deux photodétecteurs.

Cependant, dans d'autres modes de réalisation, il pourrait comprendre seulement deux photodétecteurs destinés à jouer le rôle des deux photodétecteurs des dispositifs connus, photodétecteurs qui sont respectivement situés au bord des deux éléments aboutés.

Plus l'élément complémentaire comprend de photodétecteurs (remplaçant des photodétecteurs des éléments aboutés) et plus il est possible d'éloigner les bord de découpe de ces éléments aboutés des premier photodétecteurs de ces éléments de détection.

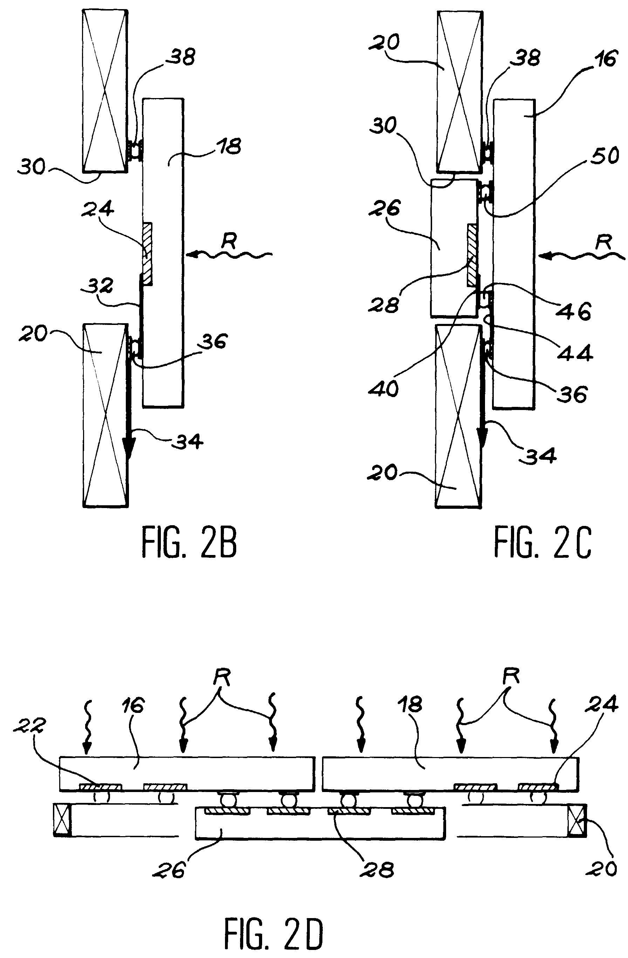

On voit sur les figures 2B, 2C et 2D, que l'éclairage du dispositif est réalisé par la face arrière des éléments 16 et 18 et qu'aucun photodétecteur n'est présent, sur ces éléments 16 et 18, à la jonction entre ceux-ci.

Ainsi, le rayonnement R à détecter traverse ces éléments 16 et 18 pour éclairer les photodétecteurs de l'élément complémentaire 26 (qui constitue une sorte de pont de détection).

On voit aussi sur la figure 2D que le rayonnement R traverse les éléments 16 et 18 pour parvenir aux photodétecteurs 22 et 24 de ces éléments qui absorbent ce rayonnement.

A titre purement indicatif et nullement limitatif, on peut réaliser un dispositif conforme à l'invention constitué par une barrette de 2000 pixels avec un pas de pixel P de 25 µm ; la taille optique D des pixels est de 18 µm et la distance géométrique minimale $g$ entre deux bords de découpe vaut 3 µm.

Dans ce cas, la distance L maximale de détérioration permise vaut :

$$L = (P - (D + g))/2 = 2 \ \mu m$$

Si la distance L réelle vaut 4 µm, les spécifications ne peuvent être satisfaites sans réduction de la taille des photodétecteurs à la valeur :

$$D = P - (2L + g) = 14 \ \mu m,$$

ce qui réduit considérablement la taille des pixels en regard de la valeur du pas.

Avec la présente invention, on peut réaliser un pixel de la même taille que le pas soit 25 µm.

On précise maintenant les diverses connexions électriques des photodétecteurs du dispositif des figures 2A à 2D.

Chaque photodétecteur de l'élément 18, comme par exemple le photodétecteur 24 (figure 2B), est muni d'un conducteur électrique de liaison 32 situé sur l'élément correspondant et est associé à un conducteur électrique de liaison 34 disposé sur le support de réseau d'interconnexion 20, ces conducteurs 32 et 34 étant électriquement reliés par l'intermédiaire d'une bille de soudure 36, ces billes 36 étant au voisinage d'un bord du perçage 30 dans l'exemple représenté.

D'autres billes de soudure 38, situées au voisinage de l'autre bord de ce perçage, sont respectivement placées en regard des billes 36 et permettent la fixation de l'élément 18 au support 20.

Chaque photodétecteur 28 de l'élément complémentaire 26 (figure 2C) est muni d'un conducteur électrique de liaison 40 placé sur la face-avant de l'élément 26 et associé à un conducteur électrique de liaison 34 placé sur le support 20.

Un autre conducteur électrique de liaison 44 est associé à ce conducteur 40 et placé sur la face avant de l'élément de photodétection 16 en regard duquel se trouve le photodétecteur 28.

Une bille de soudure 46 permet de relier le conducteur 40 au conducteur 44 et ce dernier est relié au conducteur 34 par l'intermédiaire d'une bille de soudure 36, comme on le voit sur la figure 2C.

Dans l'exemple représenté, d'autres billes de soudure 50, placées en regard des billes 46, à l'opposé de celles-ci par rapport aux photodétecteurs 28 permettent la fixation de l'élément 26 aux éléments 16 et 18.

On explique ci-après un procédé de fabrication du dispositif des figures 2A à 2D.

En ce qui concerne l'hybridation flip-chip, le mode de réalisation des billes de soudure est bien connu dans l'état de la technique.

Ces billes peuvent être, par exemple, réalisées par croissance électrolytique d'une couche de matériau à bas point de fusion au-dessus d'une surface mouillable (par exemple une surface d'or).

On réalise les billes 36 et 38 sur le support de réseau d'interconnexion 20, qui peut être en silicium, en alumine ou tout autre matériau convenant à ce genre de substrat (dont le perçage est réalisé de façon connue dans l'état de la technique).

On réalise les billes 46 et 50 sur les éléments 16 et 18 et/ou l'élément complémentaire 26.

Ces billes étant formées, on réalise alors l'hybridation flip-chip de l'ensemble des éléments aboutés 16 et 18 sur le support percé 20.

Ensuite, on hybride l'élément complémentaire 26 (après avoir retourné l'ensemble formé par le support 20 et les éléments 16 et 18 aboutés).

L'hybridation de l'élément 26 se fait à travers le perçage 30.

On peut éventuellement ramener dans un même plan les surfaces des éléments de détection aboutés 16 et 18 et de l'élément complémentaire 26, si l'on usine au préalable des cavités dans les substrats (éléments, support) destinés à recevoir des billes afin de loger ces billes dans ces cavités.

On voit sur la figure 2D que les pixels de l'élément complémentaire 26 sont éclairés par le rayonnement R à travers une épaisseur de matériau identique à celle du matériau des éléments aboutés (évidement, c'est obligatoirement l'un de ces deux éléments aboutés qui est traversé par le rayonnement).

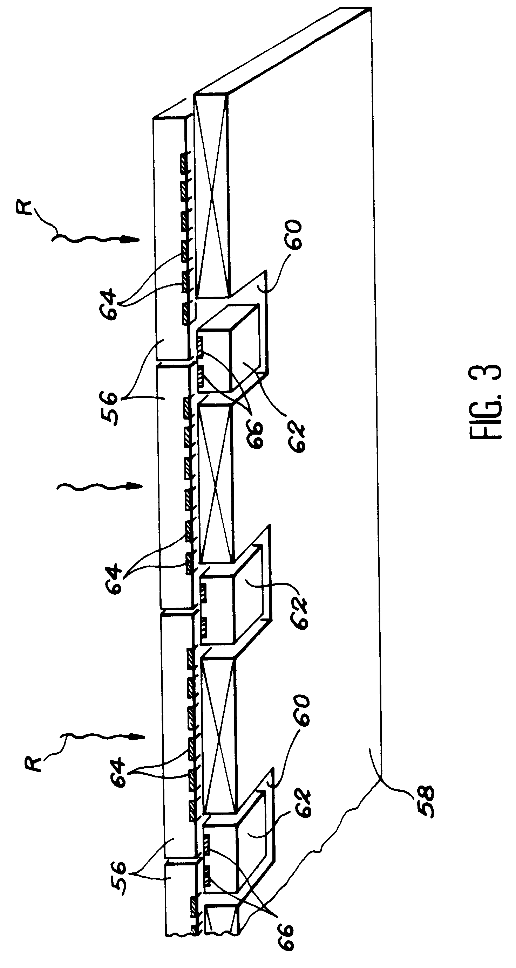

Un autre dispositif conforme à l'invention est schématiquement représenté en perspective sur la figure 3 et comprend une pluralité d'éléments de détection aboutés 56 et hybridé sur un support de réseau d'interconnexion 58.

Le support 58 comprend des perçages 60 en regard des jonctions des éléments aboutés 56 et des éléments de détection complémentaires 62 sont placés dans ces perçages.

Chaque élément 56 (qui est fait d'un matériau transparent au rayonnement R à détecter) comprend une rangée de photodétecteurs 64 et chaque élément complémentaire 62 comprend une pluralité de photodétecteurs 66, sur sa face qui est en regard des faces des éléments aboutés 56, faces sur lesquelles se trouvent les photodétecteurs 64.

Ces éléments 56 ne comportent aucun photodétecteur en regard des photodétecteurs 66 des éléments complémentaires 62.

Les billes servant à l'hybridation des divers éléments ne sont pas représentées.

Dans l'exemple représenté sur la figure 3, chaque élément complémentaire 62 ne comporte que deux photodétecteurs 66.

Ceux-ci remplacent dans ce cas les photodétecteurs absents des éléments 56, sur le bord de ces éléments 56, et permettent de rétablir la continuité des rangées de photodétecteurs 64.

On obtient ainsi l'équivalent d'une barrette de très grande longueur, à photodétecteurs régulièrement espacés les uns des autres.

Dans un autre mode de réalisation non représenté, le support 58 ne comporte qu'un seul perçage longitudinal dans lequel sont logés les éléments complémentaires 62.

**Revendications**

1. Dispositif de détection de rayonnement, ce dispositif comprenant au moins deux éléments de détection aboutés (16, 18; 56), chaque élément étant fait d'un matériau transparent au rayonnement et ayant, sur une face, une pluralité de photodétecteurs (22, 24; 64) aptes à détecter le rayonnement, ce dispositif étant caractérisé en ce qu'il comprend en outre, pour tout ensemble de deux éléments aboutés, un élément de détection complémentaire (26; 62) ayant, sur une face, une pluralité de photodétecteurs (28; 66) aptes à détecter le rayonnement, en ce que cet élément complémentaire est placé à cheval sur les deux éléments aboutés, les photodétecteurs de cet élément complémentaire étant en regard desdites faces de ces deux éléments aboutés, et en ce que ces deux éléments aboutés ne comportent aucun photodétecteur en regard des photodétecteurs de l'élément complémentaire.

2. Dispositif selon la revendication 1, caractérisé en ce qu'il comprend en outre un substrat (20; 58) comportant au moins un perçage (30; 60), ce perçage étant apte à recevoir l'élément complémentaire, en ce que les deux éléments aboutés sont hybridés sur le substrat par des billes électriquement conductrices (36, 38) et en ce que l'élément de détection complémentaire est relié au substrat par l'intermédiaire de connexions électriques (44) formées sur les éléments aboutés et de billes électriquement conductrices (36, 46).

3. Dispositif selon la revendication 2, caractérisé en ce que le substrat comprend un seul perçage (30), apte à recevoir chaque élément complémentaire (26), ou une pluralité de perçages (60), chacun de ceux-ci étant apte à recevoir un élément complémentaire (62).

4. Dispositif selon l'une quelconque des revendications 1 à 3, caractérisé en ce que chacun des éléments aboutés ainsi que l'élément complémentaire correspondant comprennent une rangée de photodétecteurs de pas déterminé, et en ce que le nombre de photodétecteurs de l'élément complémentaire est choisi de façon à obtenir, lorsque cet élément complémentaire est placé à cheval sur les éléments aboutés correspondants, une rangée unique de photodétecteurs ayant ledit pas déterminé.

5. Procédé de fabrication du dispositif selon la revendication 2, caractérisé en ce qu'il comprend les étapes suivantes :

   - on fabrique le substrat (20) pourvu dudit perçage (30),
   - on réalise l'hybridation des éléments de détection aboutés (16, 18) sur ce substrat, et
   - on assemble l'élément complémentaire (26) à la structure ainsi obtenue, à travers le perçage (30) du substrat (20).

**Patentansprüche**

1. Vorrichtung zur Strahlendetektion, wenigstens zwei aneinandergefügte Detektionselemente (16, 18; 56) umfassend, wobei jedes Element aus einem strahlungsdurchlässigen Material gemacht ist und auf einer Seite eine Vielzahl Photodetektoren (22, 24; 64), fähig die Strahlung zu detektieren, umfaßt, **dadurch gekennzeichnet,**
daß sie außerdem ein den beiden aneinandergefügten Elementen gemeinsames zusätzliches Detektionselement (26; 62) umfaßt, das auf einer Seite eine Vielzahl Photodetektoren (28; 66) aufweist, fähig die Strahlung zu detektieren, und dadurch, daß dieses Zusatzelement sich über den beiden aneinandergefügten Elementen erstreckt, wobei die Photodetektoren dieses Zusatzelements den genannten Seiten dieser beiden aneinandergefügten Elemente gegenüberstehen, und dadurch, daß diese beiden aneinandergefügten Elemente keinen den Photodetektoren des Zusatzelements gegenüberstehenden Photodetektor umfassen.

2. Vorrichtung nach Anspruch 1, dadurch gekennzeichnet, daß sie außerdem ein Substrat (20; 58) mit wenigstens einer Lochung (30; 60) umfaßt, wobei diese Lochung das Zusatzelement aufnehmen kann, dadurch, daß die beiden aneinandergefügten Elemente durch elektrisch leitende Kugeln (36, 38) auf das Substrat hybridisiert sind, und dadurch, daß das Zusatzdetektionselement mit dem Substrat durch elektrische Verbindungen (44), ausgebildet auf den aneinandergefügten Elementen, und elektrisch leitende Kugeln (36, 46) verbunden ist.

3. Vorrichtung nach Anspruch 2, dadurch gekennzeichnet, daß das Substrat eine einzige Lochung (30) zur Aufnahme jedes Zusatzelements (26) umfaßt oder eine Vielzahl von Lochungen (60), von denen jede ein Zusatzelement (62) aufnehmen kann.

4. Vorrichtung nach einem der Ansprüche 1 bis 3, dadurch gekennzeichnet, daß jedes der aneinandergefügten Elemente sowie das entsprechende Zusatzelement eine Photodetektorenreihe mit bestimmter Teilung umfaßt, und dadurch, daß die Anzahl der Photodetektoren des Zusatzelements so gewählt ist, daß man, wenn dieses Zusatzelement sich über die entsprechenden aneinandergefügten Elemente erstreckt, eine einzige Photodetektorenreihe mit der genannten Teilung erhält.

5. Verfahren zur Herstellung der Vorrichtung nach Anspruch 2, dadurch gekennzeichnet, daß es die folgenden Schritte umfaßt:

- man stellt das Substrat (20) ohne die genannte Lochung (30) her,
- man führt die Hybridisierung der aneinandergefügten Detektionselemente (16, 18) auf diesem Substrat durch, und
- man baut das Zusatzelement (26) mit der so erhaltenen Struktur zusammen, durch das Loch (30) des Substrats (20).

**Claims**

1. Radiation detection device incorporating at least two abutting detection elements (16, 18, 56), each element being made from a material transparent to the radiation and having, on one face, a plurality of photodetectors (22, 24, 64) able to detect the radiation, said device being characterized in that it also comprises, for both abutting elements, a complimentary detection element (26, 62) having, one one face, a plurality of photodetectors (28, 66) able to detect the radiation, in that said complimentary element is placed astride the two abutting elements, the photodetectors of said complimentary elements being positioned facing said faces of the two abutting elements, and in that said two abutting elements have no photodetector facing the photodetectors of the complimentary element.

2. Device according to claim 1, characterized in that it also comprises a substrate (20, 58) having at least one opening (30, 60), said opening being able to receive the complimentary element, in that the two abutting elements are hybridized on the substrate by electrically conductive balls (36, 38) and in that the complimentary detection element is connected to the substrate by means of electrical connections (44) formed on the abutting elements and the electrically conductive balls (36, 46).

3. Device according to claim 2, characterized in that the substrate comprises a single opening (30) able to receive each complimentary element (26), or a plurality of openings (60), each being able to receive one complimentary element (62).

4. Device according to any one of the claims 1 to 3, characterized in that each of the abutting elements, as well as the corresponding complimentary element comprises a row of photodetectors having a given step size and in that the number of photodetectors of the complimentary element is chosen so as to obtain, when said complimentary element is placed astride the corresponding abutting elements, a single row of photodetectors having said given step size.

5. Process for the production of the device according to claim 2, characterized in that it comprises the following stages:

- the substrate (20) provided with the opening (30) is produced,
- the abutting detection elements (16, 18) are hybridized on said substrate, and
- the complimentary element (26) is assembled with the thus obtained structure through the opening (30) of the substrate (20).

FIG. 1A

FIG. 1B

FIG. 2A

FIG. 2B

FIG. 2C

FIG. 2D

FIG. 3